# EUROPEAN PATENT APPLICATION

(11) **EP 4 199 062 A1**
(43) Date of publication of application: **21.06.2023**
(21) Application number: 22206578.1
(22) Date of filing: 10.11.2022
(51) Int. Cl.: H01L 21/822, H01L 21/8234, H01L 27/06, H01L 27/088, H01L 29/417, H01L 29/66, H01L 29/775, H01L 27/092, H01L 21/8238

(54) **NON-REACTIVE EPI CONTACT FOR STACKED TRANSISTORS**

(30) Priority: 20.12.2021 US 202117556737
(71) Applicant: INTEL Corporation, Santa Clara, CA 95054 (US)
(72) Inventor: RADOSAVLJEVIC, Marko, Portland, 97229 (US); DEWEY, Gilbert, Beaverton, 97006 (US); RACHMADY, Willy, Beaverton, 97007 (US); AGRAWAL, Ashish, Hillsboro, 97124 (US); MORROW, Patrick, Portland, 97229 (US); SUNG, Seung Hoon, Portland, 97229 (US); HUANG, Cheng-Ying, Hillsboro, 97124 (US); THOMAS, Nicole, Portland, 97209 (US); HARATIPOUR, Nazila, Portland, 97229 (US)
(74) Representative: HGF

(57) **Abstract**

Techniques are provided herein to form semiconductor devices having a non-reactive metal contact in an epi region of a stacked transistor configuration. An n-channel device may be located vertically above a p-channel device (or vice versa). Source or drain regions are adjacent to both ends of the n-channel and the p-channel, such that a source or drain region of one device is located vertically over the source or drain region of the other device. A deep and narrow contact is formed from either the frontside or the backside of the integrated circuit through the stacked source or drain regions. According to some embodiments, the contact is formed using a refractory metal or other non-reactive metal such that no silicide or germanide is formed with the epi material of the source or drain regions at the boundary between the contact and the source or drain regions.

## Description

### FIELD OF THE DISCLOSURE

The present disclosure relates to integrated circuits, and more particularly, to the epi region contact formation for transistor devices.

### BACKGROUND

As integrated circuits continue to scale downward in size, a number of challenges arise. For instance, reducing the size of memory and logic cells or otherwise increasing device density is becoming increasingly more difficult. One possible solution to increase device density is to stack transistor devices in a vertical direction. As a result, providing contacts to the structures of such stacked devices becomes difficult. There are many non-trivial challenges involved with the fabrication of such stacked devices and the fabrication of contacts to the associated device structures.

### BRIEF DESCRIPTION OF THE DRAWINGS

Figure 1 is a cross-sectional view of an example integrated circuit having a semiconductor device with a particular contact structure in the epi region, in accordance with an embodiment of the present disclosure.
Figures 2A - 2J are cross-sectional views that collectively illustrate an example process for forming a semiconductor device having a non-reactive metal contact in the epi region, in accordance with some embodiments of the present disclosure.
Figure 3 illustrates a cross-section view of a chip package containing one or more semiconductor dies, in accordance with some embodiments of the present disclosure.
Figure 4 is a flowchart of a fabrication process for a semiconductor device having a non-reactive metal contact in the epi region, in accordance with an embodiment of the present disclosure.
Figure 5 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form gate-all-around (GAA) semiconductor devices having a non-reactive metal contact in an epi region of a stacked transistor configuration. The techniques can be used in any number of transistor technologies, but are particularly useful in a stacked nanoribbon transistor configuration (e.g., stacked in a vertical z-direction from the substrate surface) or forksheet transistor configuration. In one example, two different semiconductor devices of a given memory or logic cell such as a synchronous random access memory (SRAM) cell, or a complementary metal oxide semiconductor (CMOS) cell, include a p-channel device and an n-channel device. More specifically, the n-channel device and the p-channel device may both be GAA transistors each having any number of nanoribbons extending in the same direction where the n-channel device is located vertically above the p-channel device (or vice versa). Source or drain regions are adjacent to both ends of the n-channel device and the p-channel device, such that a source or drain region of one device is located vertically over the source or drain region of the other device. A deep and narrow contact may be formed from either the frontside or the backside of the integrated circuit through the stacked source or drain regions. A frontside contact may extend through an entire thickness of a top source or drain region and through a portion of a bottom source or drain region. A backside contact may extend through an entire thickness of the bottom source or drain region and through a portion of the top source or drain region. According to some embodiments, the contact is formed using a refractory metal or other non-reactive metal. In other words, no reactive metals that could form silicide or germanide with the epi material of the source or drain regions are used in the contact. By using a non-reactive metal for the contact, consumption of the epitaxial material in the source or drain regions is reduced compared to other contact materials. Numerous variations and embodiments will be apparent in light of this disclosure.

### General Overview

As previously noted above, there remain a number of non-trivial challenges with respect to designing gate-all-around (GAA) semiconductor devices. In the case of stacked nanoribbon transistors, for example, the stacked structures can cause complications for providing electrical contact to the lower structures. For example, source or drain epi regions may be stacked over one another with an insulative barrier layer between them. In order to contact the lower source or drain epi region, a narrow contact may be formed from the frontside through the top source or drain region and through the barrier layer to also contact the bottom source or drain region. However, the contact area between the contact and the bottom source or drain region is small compared to the top source or drain region, which can cause problems with the device operation. Furthermore, forming such a deep and narrow contact brings numerous fabrication challenges. The deeper the contact, the wider it can become, and the epitaxial material becomes consumed. Silicide formation at the edge of the contact further consumes the epitaxial material and can greatly increase the contact resistance, especially if any portions of the epitaxial material closer to the ends of the semiconductor nanoribbons become consumed.

Thus, and in accordance with an embodiment of the present disclosure, techniques are provided herein to form a frontside or backside contact using a single refractory or other non-reactive metal to provide sufficient contact area to both the top and bottom source or drain regions while reducing the consumption of the surrounding epitaxial material. A frontside contact may be formed through an entire thickness of a top source or drain region and extend at least partially into a bottom source or drain region, or a backside contact may be formed through an entire thickness of the bottom source or drain region and extend at least partially into the top source or drain region. As noted above, the contact may be formed using a single refractory metal or non-reactive metal in order to avoid the formation of any silicide or germanide on the edges of the contact. Examples of suitable refractive metal materials include tungsten (W), molybdenum (Mo), ruthenium (Ru), or cobalt (Co). In some examples, non-reactive metal compounds such as molybdenum silicide (MoSi) or tantalum silicide (TaSi) may be formed in a gaseous state and deposited as a solid contact material without further reacting with the epi material in the source or drain regions. Alloys of any of the aforementioned metals (e.g., W, Mo, Ru, Co, Ta, or Nb) may also be used along with carbides of some of the materials (e.g., WC, WCN, MoC, TaC, TiC, or RuC). Additionally, the contact may be formed within a recess by first depositing the metal material using a physical vapor deposition (PVD) process to coat the inner sidewalls of the recess and then fill the remaining portion of the recess with the metal material using a chemical vapor deposition (CVD) process. This deposition procedure may be used to minimize or eliminate fluorine contamination of the epitaxial material during CVD. Although description herein focuses on the use of GAA transistor configurations, the techniques can be applied to other channel configurations as well, such as forksheet transistors.

According to an embodiment, an integrated circuit includes a first semiconductor device having one or more first semiconductor bodies (e.g., nanoribbons) extending in a first direction between a first source or drain region and a second source or drain region and a second semiconductor device having one or more second semiconductor bodies extending in the first direction between a third source or drain region and a fourth source or drain region. The one or more first semiconductor bodies are spaced vertically from the one or more second semiconductor bodies in a second direction different from the first direction and the third source or drain region is spaced vertically from the first source or drain region in the second direction. The integrated circuit also includes an insulating layer between the first source or drain region and the third source or drain region, and a conductive contact extending through an entire thickness of the third source or drain region and at least a portion of a thickness of the first source or drain region. The conductive contact has a same material composition present throughout an entire body of the conductive contact, and the conductive contact directly contacts a portion of the third source or drain region and a portion of the first source or drain region.

According to an embodiment, an integrated circuit includes a first semiconductor device having one or more first semiconductor bodies extending in a first direction between a first source or drain region and a second source or drain region and a second semiconductor device having one or more second semiconductor bodies extending in the first direction between a third source or drain region and a fourth source or drain region. The one or more first semiconductor bodies are spaced vertically from the one or more second semiconductor bodies in a second direction different from the first direction and the third source or drain region is spaced vertically from the first source or drain region in the second direction. The integrated circuit also includes an insulating layer between the first source or drain region and the third source or drain region, and a conductive contact extending through an entire thickness of the third source or drain region and at least a portion of a thickness of the first source or drain region. The conductive contact includes a conductive layer directly contacting a portion of the third source or drain region and a portion of the first source or drain region, and a conductive material on the conductive layer. The conductive material has a same refractory metal as the conductive layer.

According to another embodiment, a method of forming an integrated circuit includes forming a multilayer fin having a first section with first material layers alternating with second material layers, the second material layers comprising a semiconductor material suitable for use as a nanoribbon channel, and a second section over the first section and comprising third material layers alternating with fourth material layers, wherein the fourth material layers comprise a semiconductor material suitable for use as a nanoribbon channel; forming a first source or drain region coupled to the ends of the second material layers; forming an insulating layer over the first source or drain region; forming a second source or drain region coupled to the ends of the fourth material layers and over the insulating layer; forming a recess through an entire thickness of the second source or drain region and through at least a portion of the first source or drain region; lining walls of the recess with a first conductive material using a first deposition technique; and filling a remaining portion of the recess with a second conductive material using a second deposition technique different from the first deposition technique.

The techniques are especially suited for use with stacked gate-all-around transistors such as nanowire, nanoribbon, or nanosheet transistors, but may also be applicable in some instances to finFET devices (e.g., stacked finFET structures). The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate electrode can be implemented with a gate-first process or a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate an epi contact in a stacked transistor configuration that extends through portions of both a top source or drain region and bottom source or drain region, where the contact does not have any silicide or germanide on it. In some examples, the epi contact may be observed as only including a single refractory metal, such as only including W, only Mo, only Ru, or only Co.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

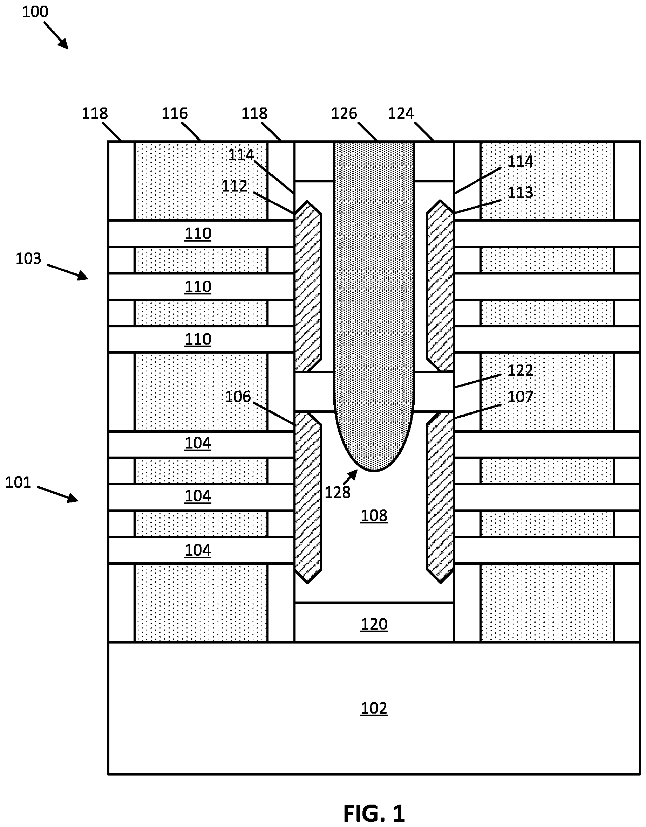

Figure 1 is a cross sectional view of a portion of an integrated circuit 100 that includes a first semiconductor device 101 and a second semiconductor device 103, where second semiconductor device 103 is stacked vertically over first semiconductor device 101, according to an embodiment of the present disclosure. The cross-section view is taken lengthwise (perpendicular to gate structure) across first semiconductor device 101 and second semiconductor device 103 in a first direction while the devices are vertically stacked over one another in a second direction substantially orthogonal to the first direction. Each of semiconductor devices 101 and 103 may be gate-all-around (GAA) transistors, although other transistor topologies and types could also benefit from the techniques provided herein. The illustrated embodiments herein use the GAA structure. Semiconductor devices 101 and 103 represent a portion of integrated circuit 100 that may contain any number of similar semiconductor devices. While other semiconductor devices may be illustrated, such as the stacked devices on the right of Figure 1, reference herein is made to the structures of semiconductor devices 101 and 103 for ease of discussion. The description of such structures may apply equally to the corresponding structures of other stacked semiconductor devices in integrated circuit 100.

As can be seen, integrated circuit 100 is formed over a substrate 102. Substrate 102 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 102 can be a semiconductor-on-insulator substrate having a desired semiconductor layer over a buried insulator layer (e.g., silicon over silicon dioxide). Alternatively, substrate 102 can be a multilayer substrate or superlattice suitable for forming nanowires or nanoribbons (e.g., alternating layers of silicon and SiGe, or alternating layers indium gallium arsenide and indium phosphide). Any number of substrates can be used.

In some embodiments, substrate 102 is removed during backside processing and replaced with a dielectric base layer. Backside interconnect structures such as backside contacts may be formed through the dielectric base layer to contact semiconductor device structures from below.

First semiconductor device 101 may include any number of semiconductor nanoribbons 104 extending between a first source or drain region and a second source or drain region (not illustrated). According to some embodiments, the first source or drain region includes epitaxially grown material that is shared between semiconductor nanoribbons 104 of first semiconductor device 101 and semiconductor nanoribbons of an adjacent semiconductor device. According to some embodiments, the first source or drain region includes different epitaxial regions. For example, the first source or drain region includes first epitaxial portions 106 and 107 that are grown directly from the tips of semiconductor nanoribbons 104 and the semiconductor nanoribbons of the adjacent device, respectively, and a second epitaxial portion 108 that fills in the remaining area around the first epitaxial portions 106/107. In some examples, first epitaxial portion 106 represents individual nubs or islands of epitaxial material grown from the ends of each of semiconductor nanoribbons 104, such that the epitaxial growths do not all merge together. In some examples, like the one illustrated, such epitaxial growths from the ends of each of semiconductor nanoribbons 104 merge together along the side of the device. According to some embodiments, second epitaxial portion 108 is formed over first epitaxial portions 106 and 107 and has a higher dopant concentration compared to first epitaxial portions 106 and 107.

Second semiconductor device 103 may include any number of semiconductor nanoribbons 110 extending between a third source or drain region and a fourth source or drain region (not illustrated). According to some embodiments, the third source or drain region includes epitaxially grown material that is shared between semiconductor nanoribbons 110 of second semiconductor device 103 and semiconductor nanoribbons of an adjacent semiconductor device. According to some embodiments, the third source or drain region includes different epitaxial regions. For example, the third source or drain region includes first epitaxial portions 112 and 113 that are grown directly from the tips of semiconductor nanoribbons 110 and the semiconductor nanoribbons of the adjacent device, respectively, and a second epitaxial portion 114 that fills in the remaining area around the first epitaxial portions 112/113. In some examples, first epitaxial portion 112 represents individual nubs or islands of epitaxial material grown from the ends of each of semiconductor nanoribbons 110, such that the epitaxial growths do not all merge together. In some examples, like the one illustrated, such epitaxial growths from the ends of each of semiconductor nanoribbons 110 merge together along the side of the device. According to some embodiments, second epitaxial portion 114 is formed over first epitaxial portions 112 and 113 and has a higher dopant concentration compared to first epitaxial portions 112 and 113.

Any of the source or drain regions may act as either a source region or a drain region, depending on the application and dopant profile. In some embodiments, semiconductor devices 101 and 103 have an equal number of nanoribbons, while in other embodiments they have an unequal number of nanoribbons. In some embodiments, each of nanoribbons 104 and nanoribbons 110 are formed from a fin of alternating material layers (e.g., alternating layers of silicon and silicon germanium) where sacrificial material layers are removed between nanoribbons 104 and nanoribbons 110. Each of nanoribbons 104 and nanoribbons 110 may include the same semiconductor material as underlying substrate 102 (which may be later removed to form a base dielectric layer.) In any such cases, and according to some embodiments, a vertical distance between about 30 nm and about 80 nm separates the nanoribbons 104 of first semiconductor device 101 from the nanoribbons 110 of second semiconductor device 103. Other embodiments may have a smaller or larger such vertical distance.

Any semiconductor materials suitable for source and drain regions can be used (e.g., group IV and group III-V semiconductor materials) for any of the illustrated source or drains regions. In any such cases, the composition and doping of the source and drain regions may be the same or different, depending on the polarity of the transistors. In an example, for instance, one transistor is a p-type MOS (PMOS) transistor, and the other transistor is an n-type MOS (NMOS) transistor. Any number of source and drain configurations and materials can be used.

A gate structure 116 is provided over each of nanoribbons 104 and nanoribbons 110 in a shared gate architecture, according to some embodiments. In some other embodiments, a dielectric layer is present between nanoribbons 104 and nanoribbons 110 to produce a split gate architecture where a first gate structure around nanoribbons 104 is electrically isolated from a second gate structure around nanoribbons 110. The embodiments illustrated herein use the shared gate architecture but are equally applicable to split gate architectures.

Spacer structures 118 are included on either side of gate structure 116. Spacer structures 118 may include a dielectric material, such as silicon nitride, silicon oxynitride, or silicon oxycarbonitride. Gate structure 116 includes both a gate dielectric around each of nanoribbons 104 and nanoribbons 110 and a gate electrode over the gate dielectric. The gate dielectric may include a single material layer or multiple material layers. In some embodiments, the gate dielectric includes a first dielectric layer such as an oxide native to nanoribbons 104 and 110 (e.g., silicon oxide) and a second dielectric layer that includes a high-k material (e.g., such as hafnium oxide). The high-k dielectric material may be doped with an element to affect the threshold voltage of the given semiconductor device. In other embodiments, the gate dielectric only includes high-k dielectric material; in still other embodiments, the gate dielectric only includes regular-k dielectric material (e.g., silicon oxide). In some embodiments, the gate dielectric around nanoribbons 104 has a different element doping concentration compared to the gate dielectric around nanoribbons 110. According to some embodiments, the doping element used in the gate dielectric is lanthanum.

According to some embodiments, the gate electrode extends over the gate dielectric around each of nanoribbons 104 and nanoribbons 110 and also generally fills the remaining space between the various nanoribbons of any number of stacked semiconductor devices. The gate electrode may include any sufficiently conductive material such as a metal, metal alloy, or doped polysilicon. In some embodiments, the gate electrode includes one or more work-function metals around nanoribbons 104 and 110. In some embodiments, semiconductor device 101 is a p-channel device that includes n-type dopants within nanoribbons 104 and includes a work-function metal having titanium around nanoribbons 104 and semiconductor device 103 is an n-channel device that includes p-type dopants within nanoribbons 110 and includes a work-function metal having tungsten around nanoribbons 110. N-type dopants may also be used within the nanoribbons of an n-channel device and p-type dopants may be used within the nanoribbons of a p-channel device in order to tune the transistor's threshold voltage. The gate electrode may also include a fill metal or other conductive material around the work-function metals to provide the whole gate electrode structure. According to some embodiments, the gate structure may be interrupted between any adjacent semiconductor devices in a third direction orthogonal to both the first and second directions by a gate cut structure.

Returning to the epitaxial regions adjacent to the nanoribbons, a bottom dielectric layer 120 may be present to isolate the first source or drain region from any underlying substrate or other underlying material. A middle dielectric layer 122 may be present between the first source or drain region and the third source or drain region in the vertical direction to isolate the epi regions from one another. A top dielectric layer 124 may be present over the third source or drain region. Each of bottom dielectric layer 120, middle dielectric layer 122, and top dielectric layer 124 may be any suitable dielectric material, such as silicon oxide, silicon oxynitride, or silicon oxycarbonitride.

According to some embodiments, a conductive contact 126 may be formed that extends vertically (e.g., in the second direction). In some examples, conductive contact 126 is a frontside contact (as illustrated) that extends through an entire thickness of the third source or drain region, an entire thickness of middle dielectric layer 122, and through a portion of the first source or drain region. In some other examples, conductive contact 126 is a backside contact that extends through an entire thickness of the first source or drain region, an entire thickness of middle dielectric layer 122, and through a portion of the third source or drain region. According to some embodiments, conductive contact 126 includes a continuous body of refractory metal, such as ruthenium (Ru), tungsten (W), cobalt (Co), or molybdenum (Mo). In some embodiments, conductive contact 126 includes alloys of any of W, Mo, Ru, Co, Ta, or Nb. In some embodiments, conductive contact 126 includes carbides of some of the noted refractory metals, such as WC, WCN, MoC, TaC, TiC, or RuC. Such refractory metals do not react with the adjacent source or drain material, and thus no silicide or germanide forms at the boundary between conductive contact 126 and the epitaxial material of both first and third source or drain regions. According to some embodiments, the refractory metal of the conductive contact directly contacts the epitaxial material of the first and third source or drain regions. According to some embodiments, conductive contact 126 does not contact any of first epitaxial portion 106 of the first source or drain region or any of first epitaxial portion 112 of the third source or drain region.

In some embodiments, conductive contact 126 includes any suitable non-reactive metal or metal compound. For example, some metal silicides like MoSi or TaSi can be reacted together in a gaseous state and deposited as conductive contact 126. Since the compounds have already reacted, no further reaction takes place with the epi material of the source or drain regions. Accordingly, conductive contact 126 may include a consistent material composition of either a single refractory metal or non-reactive metal compound throughout the body of the conductive contact 126 with no material gradient present at the interface between conductive contact 126 and the epi material of the source or drain regions.

Due to the fabrication procedure, as will be described in more detail herein, conductive contact 126 may have a tapered end 128. According to some embodiments, conductive contact 126 may have a high aspect ratio between about 4:1 and about 8:1. In some embodiments, conductive contact 126 has a total width at the top of between about 6 nm and about 15 nm, such as around 9 nm, and a length (in the vertical direction) between about 50 nm and about 70 nm, such as around 60 nm.

According to some embodiments, a very thin adhesion layer may be present between conductive contact 126 and both the first and third source or drain regions. The adhesion layer may be less than around 1 nm thick. In some examples, the adhesion layer includes any of Ti, TiC, TiN, Ta, TaC, TaN, WC, or WCN.

### Fabrication Methodology

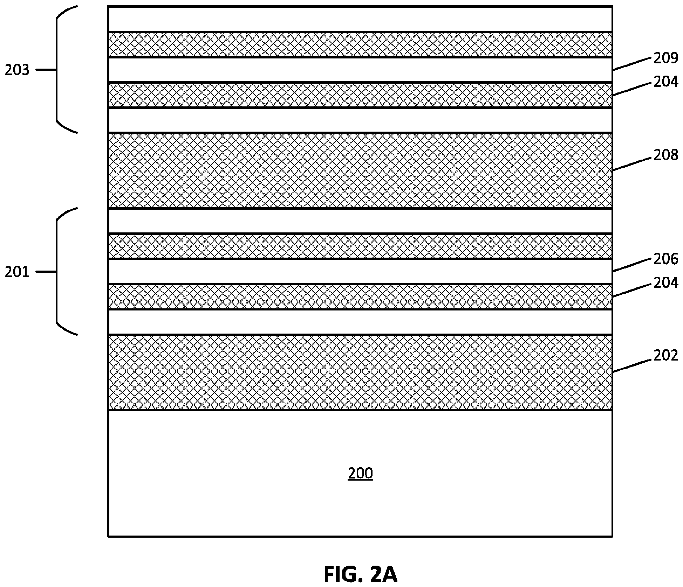

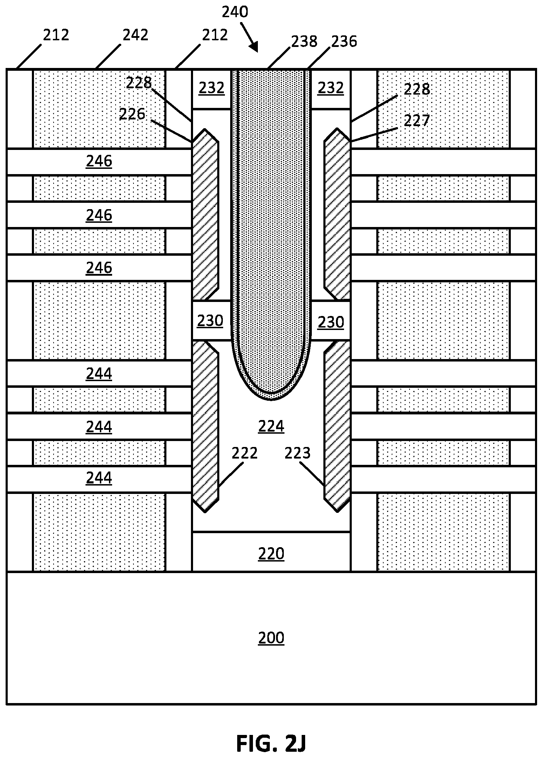

Figures 2A - 2J include cross-sectional views that collectively illustrate an example process for forming an integrated circuit configured with stacked semiconductor devices having a non-reactive epi contact. Each figure shows an example structure that results from the process flow up to that point in time, so the depicted structure evolves as the process flow continues, culminating in the structure shown in Figure 2J, which is similar to the structure illustrated in Figure 1. The illustrated integrated circuit structure may be part of a larger integrated circuit that includes other integrated circuitry not depicted. Example materials and process parameters are given, but the present disclosure is not intended to be limited to any specific such materials or parameters, as will be appreciated.

Figure 2A illustrates a cross-sectional view across a substrate 200 having a series of material layers deposited over it, according to an embodiment of the present disclosure. Substrate 200 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 200 can be a semiconductor-on-insulator substrate having a desired semiconductor layer over a buried insulator layer (e.g., silicon over silicon dioxide). Alternatively, substrate 200 can be a multilayer substrate or superlattice suitable for forming nanowires or nanoribbons (e.g., alternating layers of silicon and SiGe, or alternating layers indium gallium arsenide and indium phosphide). Any number of substrates can be used.

Alternating material layers may be deposited over substrate 200, including a first layer stack 201, a second layer stack 203, a first spacer layer 202 between first layer stack 201 and substrate 200, and a second spacer layer 208 between first layer stack 201 and second layer stack 203. Each of first and second layer stacks 201 and 203 includes sacrificial layers 204 alternating with other material layers, such as first semiconductor layers 206 of first layer stack 201 and second semiconductor layers 209 of second layer stack 203. Any number of alternating sacrificial layers 204 and material layers may be deposited within each of first layer stack 201 and second layer stack 203. Additionally, any number of layer stacks and spacer layers may be deposited over substrate 200. It should be noted that the cross section illustrated in Figure 2A is taken along the length of a fin formed from the multiple alternating layers and extending up above the surface of substrate 200.

According to some embodiments, sacrificial layers 204 have a different material composition than each of first semiconductor layers 206 and second semiconductor layers 209. In some embodiments, sacrificial layers 204 are silicon germanium (SiGe) while each of first semiconductor layers 206 and second semiconductor layers 209 include a semiconductor material suitable for use as a nanoribbon such as silicon (Si), SiGe, germanium, or III-V materials like indium phosphide (InP) or gallium arsenide (GaAs). In examples where SiGe is used in each of sacrificial layers 204 and first and second semiconductor layers 206 and 209, the germanium concentration is different between sacrificial layers 204 and first and second semiconductor layers 206 and 209. For example, sacrificial layers 204 may include a higher germanium content compared to first and second semiconductor layers 206 and 209. Each of first and second spacer layers 202 and 208 may include the same material as sacrificial layers 204. In some examples, spacer layers 202/208 can be any material that exhibits a high etch selectivity with the material of semiconductor layers 206 and 209.

While dimensions can vary from one example embodiment to the next, the thickness of each sacrificial layer 204 may be between about 5 nm and about 20 nm. In some embodiments, the thickness of each sacrificial layer 204 is substantially the same (e.g., within 1-2 nm) across each of first layer stack 201 and second layer stack 203. The thickness of each of first semiconductor layers 206 and second semiconductor layers 209 may be about the same as the thickness of each sacrificial layer 204 (e.g., about 5-20 nm). However, according to some embodiments, the thickness of first and second spacer layers 202/208 is thicker than any of sacrificial layers 204. First spacer layer 202 is provided to create a sufficient spacing between a bottom semiconductor device and substrate 200 while second spacer layer 208 is provided to create a sufficient spacing between the adjacent semiconductor devices to be formed from first semiconductor layers 206 and second semiconductor layers 209. While dimensions can vary from one example embodiment to the next, the thickness of first and second spacer layers 202/208 may be between about 30 nm to about 80 nm. Each of sacrificial layers 204, first semiconductor layers 206, second semiconductor layers 209, first spacer layer 202, and second spacer layer 208 may be deposited using any known material deposition technique, such as chemical vapor deposition (CVD), plasma-enhanced chemical vapor deposition (PECVD), physical vapor deposition (PVD), or atomic layer deposition (ALD).

First semiconductor layers 206 may be doped with either n-type dopants (to produce a p-channel transistor) or p-type dopants (to produce an n-channel transistor). Similarly, second semiconductor layers 209 may be doped with either n-type dopants (to produce a p-channel transistor) or p-type dopants (to produce an n-channel transistor).

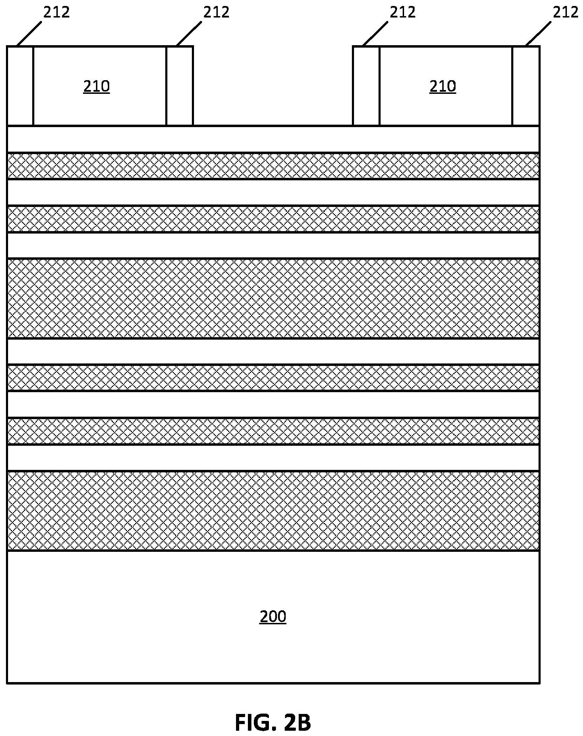

Figure 2B illustrates a cross-sectional view of the structure shown in Figure 2A following the formation of a sacrificial gate structures 210 and sidewall spacers 212 over the alternating layer structure of the fin, according to an embodiment. Sacrificial gate structures 210 may run in an orthogonal direction to the length of the fin and may include any material that can be safely removed later in the process without etching or otherwise damaging any portions of the fin or of spacer structures 212. In some embodiments, sacrificial gate structures 210 include polysilicon. Spacer structures 212 may be formed using an etch-back process where spacer material is deposited everywhere and then anisotropically etched to leave the material only on sidewalls of structures including sacrificial gate structures 210. Spacer structures 212 may include a dielectric material, such as silicon nitride, silicon oxy-nitride, or any formulation of those layers incorporating carbon or boron dopants. Each sacrificial gate structure 210 together with its associated spacer structures 212 define a portion of the fin that will be used to form a stack of transistor devices as discussed further herein.

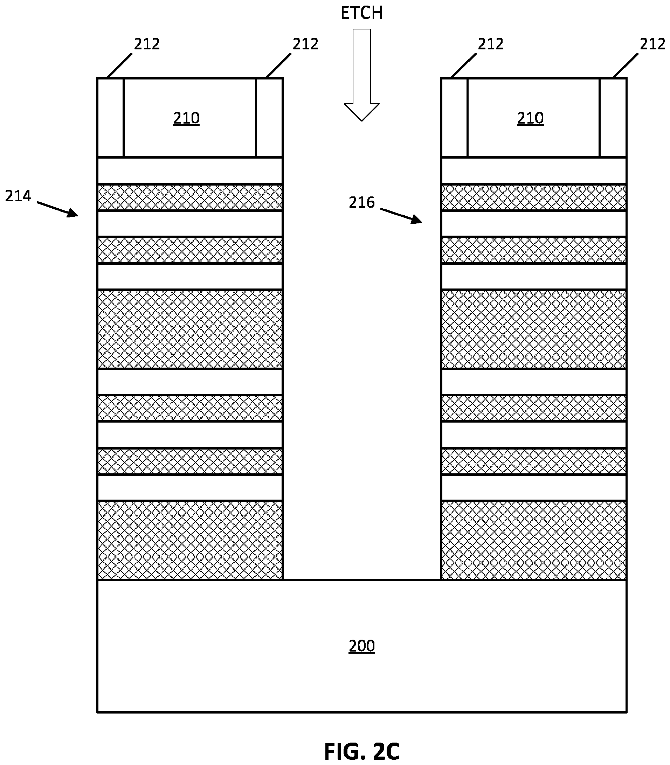

Figure 2C illustrates a cross-sectional view of the structure shown in Figure 2B following the removal of the exposed fin not under sacrificial gate structures 210 and sidewall spacers 212, according to an embodiment of the present disclosure. According to some embodiments, the various layers of the different layer stacks are etched at substantially the same rate using an anisotropic RIE process. As observed in Figure 2C, the width of spacer structures 212 works to define the length of the resulting fins 214 and 216. In some embodiments, some undercutting occurs along the edges of the fins beneath spacer structures 212 such that the lengths of the fins are not exactly the same as a sum of the widths of spacer structures 212 and a width of a given sacrificial gate structure 210. Similar to the discussion related to Figure 1, the discussion of the fabrication process herein will focus on fin 214 though the same processes may be occurring with fin 216.

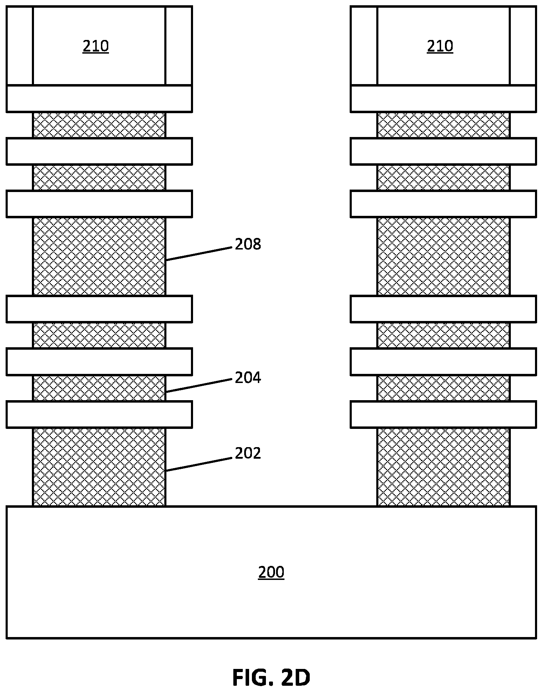

Figure 2D illustrates a cross-sectional view of the structure shown in Figure 2C following the removal of portions of sacrificial layers 204, according to an embodiment of the present disclosure. An isotropic etching process may be used to recess the exposed ends of each sacrificial layer 204 along the entire layer stack of fin 214. First and second spacer layers 202 and 208 may be recessed as well along with each sacrificial Iayer204. The isotropic etchant used exhibits a high etch selectivity between sacrificial layers 204 and each of the semiconductor layers.

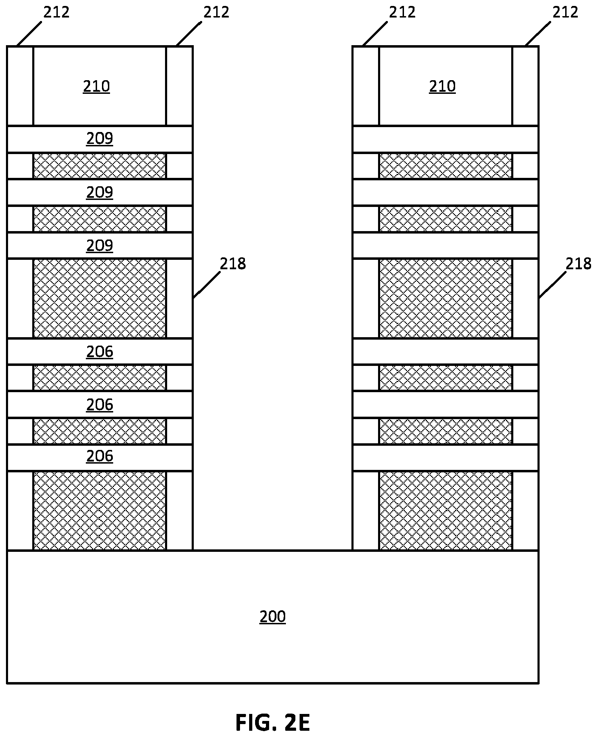

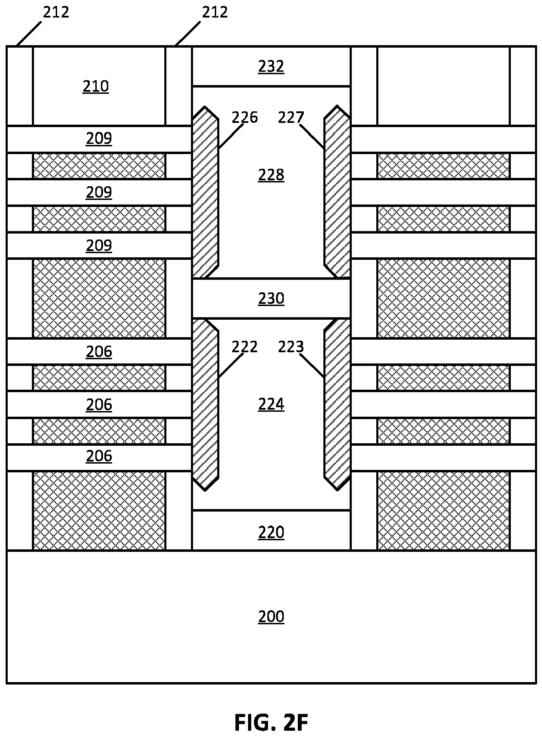

Figure 2E illustrates a cross-sectional view of the structure shown in Figure 2F following the formation of internal spacers 218, according to an embodiment of the present disclosure. Internal spacers 218 may have a material composition that is similar to or the exact same as spacer structures 212. Accordingly, internal spacers 218 may be any suitable dielectric material that exhibits high etch selectively to semiconductor materials such as silicon and/or silicon germanium. Internal spacers 218 may be conformally deposited over the sides of the fin structure using a CVD process like ALD. After the dielectric material has been deposited, an isotropic etching process is performed to remove internal spacers 218 from the tips of the semiconductor layers 206 and 209. According to some embodiments, internal spacers 218 are recessed inwards at least until the ends of both first semiconductor layers 206 and second semiconductor layers 209 are exposed.

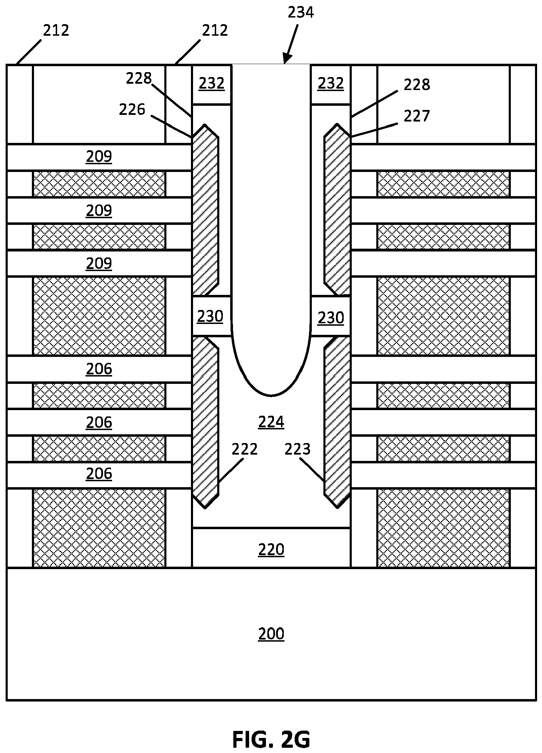

Figure 2F illustrates a cross-sectional view of the structure shown in Figure 2G following the formation of source and drain regions, according to an embodiment of the present disclosure. Due to the vertically stacked spacing between first semiconductor layers 206 and second semiconductor layers 209, a similarly stacked formation of source and drain regions is created. According to an embodiment, a bottom insulator layer 220 is first formed to isolate the epitaxial source or drain regions from substrate 200 or any other underlying layers. Accordingly, bottom insulator layer 220 may be any suitable dielectric material.

A first source or drain region is formed adjacent to the ends of first semiconductor layers 206. As noted above, the first source or drain region may include first epitaxial portions 222 and 223 and a second epitaxial portion 224 over the first epitaxial portions. The first epitaxial portion 222 may be grown directly from the exposed ends of first semiconductor layers 206. Accordingly, in some embodiments, first epitaxial portion 222 represents nubs or islands of epitaxial growth on the ends of first semiconductor layers 206, where at least some of the nubs or islands are not merged together. In other embodiments, such as the one illustrated, first epitaxial portion 222 represents merged epitaxial growths from the ends of first semiconductor layers 206. According to some embodiments, second epitaxial portion 224 is formed over first epitaxial portions 222 and 223 and has a higher dopant concentration compared to first epitaxial portions 222 and 223. In the example of a PMOS device, first epitaxial portions 222 and 223 may be a semiconductor material (e.g., group IV and group III-V semiconductor materials) having a first dopant concentration of p-type dopants (e.g., boron) while second epitaxial portion 224 is a semiconductor material (e.g., group IV and group III-V semiconductor materials) having a second dopant concentration of p-type dopants that is higher than the first dopant concentration.

As noted above, first semiconductor layers 206 extend between the first source or drain region (made up of first epitaxial portions 222/223 and second epitaxial portion 224) and a second source or drain region that would be present on the left side of first semiconductor layers 206. A third source or drain region may be formed adjacent to the ends of second semiconductor layers 209, such that second semiconductor layers 209 extend between the third source or drain region and a fourth source or drain region that would be present on the left side of second semiconductor layers 209. Similar to the first source or drain region, the third source or drain region may include first epitaxial portions 226 and 227 and a second epitaxial portion 228 over the first epitaxial portions. The first epitaxial portion 226 may be grown directly from the exposed ends of second semiconductor layers 209. Accordingly, in some embodiments, first epitaxial portion 226 represents nubs or islands of epitaxial growth on the ends of second semiconductor layers 209, where at least some of the nubs or islands are not merged together. In other embodiments, such as the one illustrated, first epitaxial portion 226 represents merged epitaxial growths from the ends of second semiconductor layers 209. According to some embodiments, second epitaxial portion 228 is formed over first epitaxial portions 226 and 227 and has a higher dopant concentration compared to first epitaxial portions 226 and 227. In the example of an NMOS device, first epitaxial portions 226 and 227 may be a semiconductor material (e.g., group IV and group III-V semiconductor materials) having a first dopant concentration of n-type dopants (e.g., phosphorous) while second epitaxial portion 228 is a semiconductor material (e.g., group IV and group III-V semiconductor materials) having a second dopant concentration of n-type dopants that is higher than the first dopant concentration.

According to some embodiments, another insulator layer 230 is formed between the first source or drain region and the third source or drain region to provide sufficient isolation between the regions. Insulator layer 230 may be any suitable dielectric material, such as the same material as bottom insulator layer 220. In some embodiments insulator layer 230 is a titanium-based dielectric. Insulator layer 230 may have a thickness between about 10 nm and about 30 nm. A top insulator layer 232 may also be formed over the third source or drain region (made up of first epitaxial portions 226/227 and second epitaxial portion 228). In some embodiments, a top surface of insulator layer 232 is planarized to be substantially level with a top surface of sacrificial gate structure 210. Polishing of the top surface of insulator layer 232 may be performed using chemical mechanical polishing, CMP.

Figure 2G illustrates a cross-sectional view of the structure shown in Figure 2F following the formation of a deep recess 234, according to an embodiment of the present disclosure. An anisotropic etching process, such as RIE, may be used to etch recess 234 through top insulator layer 232, through a thickness of the third source or drain region, and through a thickness of insulator layer 230. Recess may then extend into at least a portion of the first source or drain region, in some examples. According to some embodiments, recess 234 is aligned such that it does not expose any portion of the first epitaxial regions 226/227 of the third source or drain region or any portion of first epitaxial regions 222/223 of the first source or drain region. Thus, the recess may be formed only through second epitaxial portion 228 of the third source or drain region and through second epitaxial portion 224 of the first source or drain region. The depth of recess 234 is limited by the fabrication process as the longer the etching process is performed, the wider recess 234 can become and potentially expose any of first epitaxial portions 222/223/226/227. According to some embodiments, recess 234 has a depth between about 50 nm and about 70 nm.

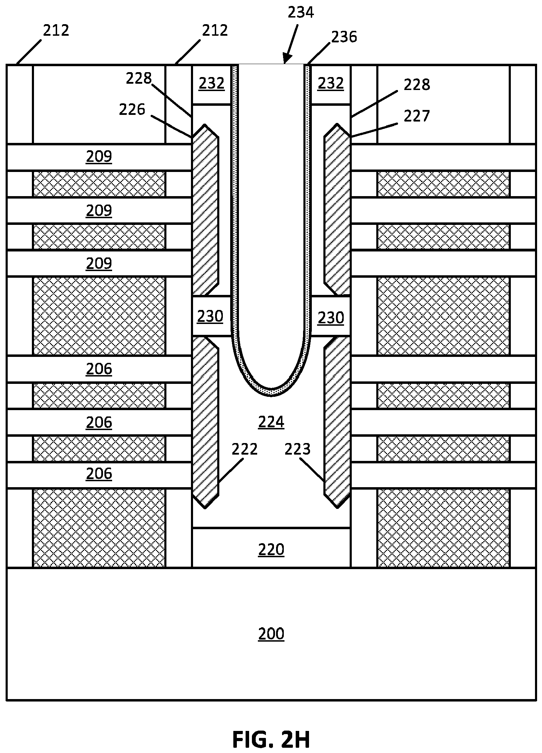

Figure 2H illustrates a cross-sectional view of the structure shown in Figure 2G following the formation of a conductive layer 236 within recess 234, according to an embodiment of the present disclosure. Conductive layer 236 includes a single refractory metal or a non-reactive metal or metal compound, according to some embodiments. For example, conductive layer 236 includes one of W, Mo, Ru, or Co. In some other examples, conductive layer 236 can include non-reactive metal compounds such as MoSi or TaSi which have been silicized before being deposited as conductive layer 236.

According to an embodiment, conductive layer 236 is deposited along the inner surface of recess 234 using a PVD process, such as sputtering or metal evaporation. Using a PVD process avoids the use of potentially reactive elements, such as fluorine, which are typically used during a CVD process. Since the fluorine may react with the exposed epitaxial material of the first and/or third source or drain regions, a PVD process is used to first deposit conductive layer 236 within recess 234.

Since conductive layer 236 is a non-reactive metal or metal compound, it does not react with the epitaxial material of first and third source or drain regions to form any silicide or germanide at the interface between conductive layer 236 and the epitaxial material, according to an embodiment. Accordingly, there is minimal or no diffusion of elements across the boundary between conductive layer 236 and the epitaxial material leading to a sharp material contrast at the boundary (e.g. no visible material gradient at the boundary).

As noted above, in some embodiments, a very thin adhesion layer is first formed on the inner surface of recess 234 before the formation of conductive layer 226. The adhesion layer may be less than around 1 nm thick. In some examples, the adhesion layer includes any of Ti, TiC, TiN, Ta, TaC, TaN, WC, or WCN.

Figure 2l illustrates a cross-sectional view of the structure shown in Figure 2H following the formation of a conductive fill 238 to complete the formation of a conductive contact 240, according to an embodiment of the present disclosure. Conductive fill 238 may include the same material composition as conductive layer236. Accordingly, conductive fill 238 includes a single refractory metal or a non-reactive metal or metal compound, according to some embodiments. For example, conductive fill 238 includes one of W, Mo, Ru, or Co. In some other examples, conductive fill 238 can include non-reactive metal compounds such as MoSi or TaSi which have been silicized before being deposited as conductive fill 238. In some embodiments, conductive fill 238 includes a different non-reactive metal or metal compound compared to conductive layer 236. In some examples, conductive contact 240 has a continuous body of conductive material with no visible seam present between conductive fill 238 and conductive layer 236. In some other examples, based on the deposition method and/or parameters, a seam may be visible between conductive fill 238 and conductive layer 236.

According to some embodiments, conductive fill 238 may be deposited using a different deposition process compared to conductive layer 236. For example, conductive fill 238 may be deposited using CVD to fill the remainder of recess 234. Any excess conductive material over the top surface of insulator layer 232 may be polished away, using CMP for example, to planarize the top surface of conductive contact 240 with the top surface of insulator layer 232.

According to some embodiments, the final conductive contact 240 includes a non-reactive metal or metal compound at least at the interface between conductive contact 240 and the epitaxial material of second epitaxial portions 224 and 228. The non-reactive metal or metal compound may also be present continuously throughout the body of conductive contact 240 such that conductive contact 240 has the same material composition throughout its entire body. According to some embodiments, conductive contact 240 has an aspect ratio between about 4:1 and about 8:1 (such as around 6:1). According to some embodiments, conductive contact 240 has a width at its widest point between about 15 nm and about 30 nm or between about 18 nm and about 24 nm, and a depth between about 50 nm and about 70 nm.

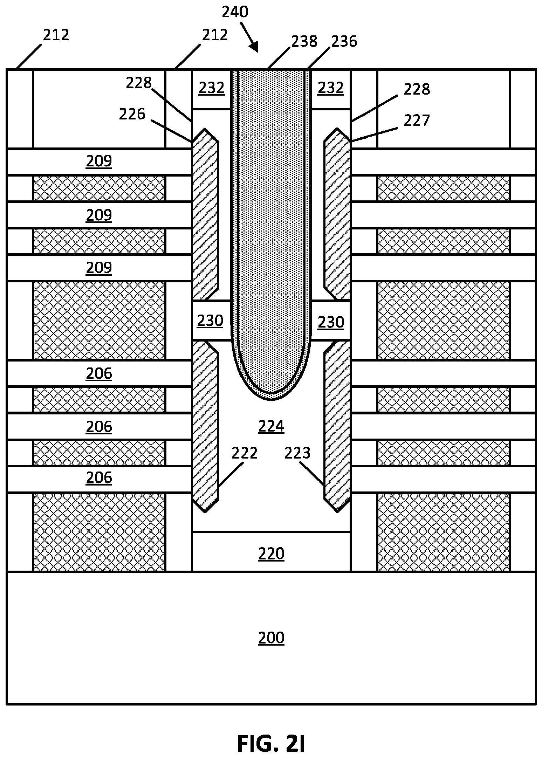

Figure 2J illustrates a cross-sectional view of the structure shown in Figure 2I following the removal of the sacrificial gate structure 210 and sacrificial layers 204 and the formation of a gate structure 242, according to an embodiment of the present disclosure. Sacrificial gate structure 210 may be removed using any wet or dry isotropic process thus exposing the alternating layer stack of the fin within the trench left behind after the removal of sacrificial gate structure 210. Once sacrificial gate structure 210 has been removed, sacrificial layers 204 (along with spacer layers 202 and 208) may also be removed using a selective isotropic etching process that removes the material of sacrificial layers 204 (along with spacer layers 202 and 208) but does not remove (or removes very little of) first semiconductor layers 206 and second semiconductor layers 209. At this point, the suspended (sometimes called released) first semiconductor layers 206 form first nanoribbons 244 that extend between the first source or drain region and the second source or drain region, and the suspended second semiconductor layers 209 form second nanoribbons 246 that extend between the third source or drain region and the fourth source or drain region.

As noted above, gate structure 242 includes a gate dielectric and a gate electrode. The gate dielectric may be conformally deposited around first nanoribbons 244 and second nanoribbons 246 using any suitable deposition process, such as ALD. The gate dielectric may include any suitable dielectric (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, molybdenum nitride, niobium nitride, and lead zinc niobate, to provide some examples. According to some embodiments, the gate dielectric is hafnium oxide with a thickness between about 1 nm and about 5 nm. In some embodiments, the gate dielectric may include one or more silicates (e.g., titanium silicate, tungsten silicate, niobium silicate, and silicates of other transition metals). The gate dielectric may be a multilayer structure, in some examples. For instance, the gate dielectric may include a first layer on first and second nanoribbons 244/246, and a second layer on the first layer. The first layer can be, for instance, an oxide of the semiconductor layers (e.g., silicon dioxide) and the second layer can be a high-k dielectric material (e.g., hafnium oxide). In some embodiments, an annealing process may be carried out on the gate dielectric to improve its quality when a high-k dielectric material is used. In some embodiments, the high-k material can be nitridized to improve its aging resistance.

The gate electrode may be deposited over the gate dielectric and can be any standard or proprietary gate structure that may include any number of gate cuts. In some embodiments, the gate electrode includes doped polysilicon, a metal, or a metal alloy. Example suitable metals or metal alloys include aluminum, tungsten, cobalt, molybdenum, ruthenium, titanium, tantalum, copper, and carbides and nitrides thereof. The gate electrode may include, for instance, one or more work-function layers, resistance-reducing layers, and/or barrier layers. The work-function layers can include, for example, p-type work-function materials (e.g., titanium nitride) for PMOS gates, or n-type work-function materials (e.g., titanium aluminum carbide) for NMOS gates. Recall the work-function layers formed around first nanoribbons 244 can be different from the work-function layers formed around second nanoribbons 246, according to some example embodiments.

As discussed above, conductive contact 240 is an example of a frontside contact that extends downwards through the third source or drain region and through a portion of the first source or drain region. However, in some embodiments, the conductive contact may be a backside contact that extends upwards through the first source or drain region and through a portion of the third source or drain region. All structural features of the backside contact, including the formation process, may be the same as conductive contact 240. In some embodiments, the backside contact may extend into only a portion of the first source or drain region and not extend into any portion of the third source or drain region.

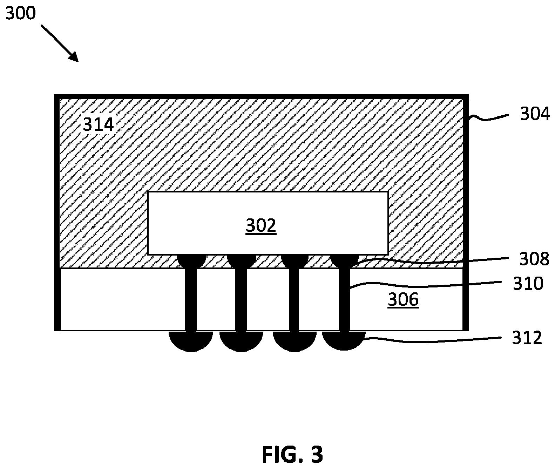

Figure 3 illustrates an example embodiment of a chip package 300, in accordance with an embodiment of the present disclosure. As can be seen, chip package 300 includes one or more dies 302. One or more dies 302 may include at least one integrated circuit having semiconductor devices, such as any of the semiconductor devices disclosed herein. One or more dies 302 may include any other circuitry used to interface with other devices formed on the dies, or other devices connected to chip package 300, in some example configurations.

As can be further seen, chip package 300 includes a housing 304 that is bonded to a package substrate 306. The housing 304 may be any standard or proprietary housing, and may provide, for example, electromagnetic shielding and environmental protection for the components of chip package 300. The one or more dies 302 may be conductively coupled to a package substrate 306 using connections 308, which may be implemented with any number of standard or proprietary connection mechanisms, such as solder bumps, ball grid array (BGA), pins, or wire bonds, to name a few examples. Package substrate 306 may be any standard or proprietary package substrate, but in some cases includes a dielectric material having conductive pathways (e.g., including conductive vias and lines) extending through the dielectric material between the faces of package substrate 306, or between different locations on each face. In some embodiments, package substrate 306 may have a thickness less than 1 millimeter (e.g., between 0.1 millimeters and 0.5 millimeters), although any number of package geometries can be used. Additional conductive contacts 312 may be disposed at an opposite face of package substrate 306 for conductively contacting, for instance, a printed circuit board (PCB). One or more vias 310 extend through a thickness of package substrate 306 to provide conductive pathways between one or more of connections 308 to one or more of contacts 312. Vias 310 are illustrated as single straight columns through package substrate 306 for ease of illustration, although other configurations can be used (e.g., damascene, dual damascene, through-silicon via, or an interconnect structure that meanders through the thickness of substrate 306 to contact one or more intermediate locations therein). In still other embodiments, vias 310 are fabricated by multiple smaller stacked vias, or are staggered at different locations across package substrate 306. In the illustrated embodiment, contacts 312 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 312, to inhibit shorting.

In some embodiments, a mold material 314 may be disposed around the one or more dies 302 included within housing 304 (e.g., between dies 302 and package substrate 306 as an underfill material, as well as between dies 302 and housing 304 as an overfill material). Although the dimensions and qualities of the mold material 314 can vary from one embodiment to the next, in some embodiments, a thickness of mold material 314 is less than 1 millimeter. Example materials that may be used for mold material 314 include epoxy mold materials, as suitable. In some cases, the mold material 314 is thermally conductive, in addition to being electrically insulating.

### Methodology

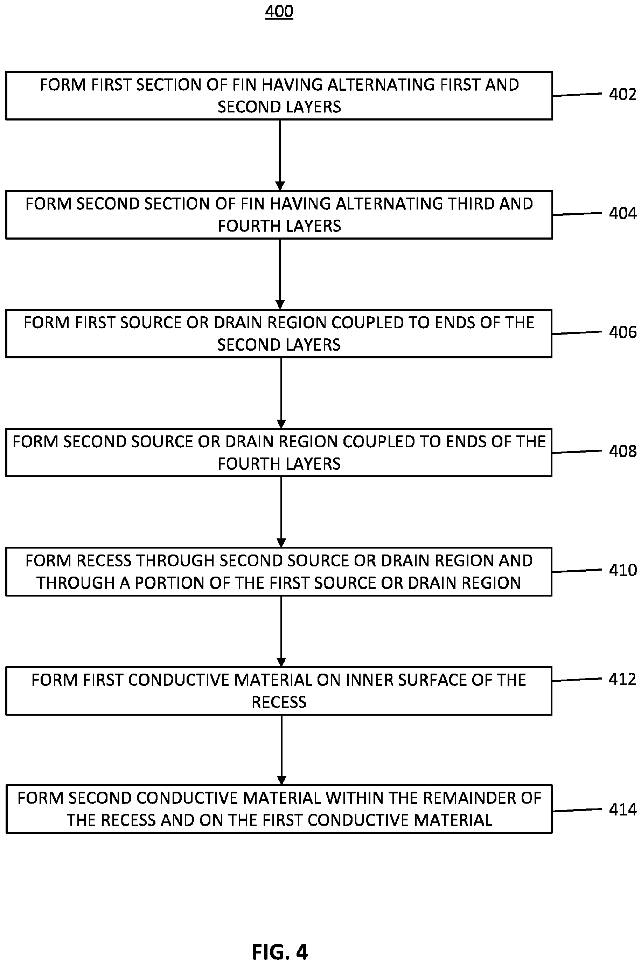

Figure 4 is a flow chart of a method 400 for forming at least a portion of an integrated circuit, according to an embodiment. Various operations of method 400 may be illustrated in Figures 2A- 2J. However, the correlation of the various operations of method 400 to the specific components illustrated in the aforementioned figures is not intended to imply any structural and/or use limitations. Rather, the aforementioned figures provide some example embodiments of method 400. Other operations may be performed before, during, or after any of the operations of method 400. Some of the operations of method 400 may be performed in a different order than the illustrated order.

Method 400 begins with operation 402 where a first section of a fin is formed having alternating first and second layers. The first layers may be sacrificial layers (e.g., comprising SiGe) while the second layers include a semiconductor material (e.g., Si, SiGe, Ge, InP, or GaAs) suitable for use as a nanoribbon channel. The first section may be formed over a substrate or over a sacrificial spacer layer. The thickness of each of the first and second layers may be between about 5 nm and about 20 nm or between about 5 nm and about 10 nm. Each of the first and second layers may be deposited using any known material deposition technique, such as CVD, PECVD, PVD, or ALD.

Method 400 continues with operation 404 where a second section of the fin is formed having alternating third and fourth layers. The third layers may be substantially the same as the first layers (sacrificial layers) with substantially the same thickness of the first layers. The fourth layers include a semiconductor material (e.g., Si, SiGe, Ge, InP, or GaAs) suitable for use as a nanoribbon channel and may include substantially the same material composition as the second layers. The thickness of each of the third and fourth layers may be between about 5 nm and about 20 nm or between about 5 nm and about 10 nm. Each of the third and fourth layers may be deposited using any known material deposition technique, such as CVD, PECVD, PVD, or ALD. According to some embodiments, the second fin section is separated from the first fin section by a sacrificial spacer layer that includes the same material composition as any of the first and third layers.

According to some embodiments, once the material layers have been deposited, one or more fins may be defined via an anisotropic etching process, such as RIE, using a patterned mask material to protect the fins from the etch. The fin height may include the alternating material layers of each of the fin sections and a subfin portion formed from the substrate material. In some other embodiments, trenches are first formed in a dielectric material and the alternating material layers of the aforementioned sections are formed within the trenches to form one or more multilayer fins. A separate fin used to define specific semiconductor devices may be further formed by patterning a sacrificial gate and gate spacer structures on sidewalls of the sacrificial gate that extend over the fin and removing portions of the fin outside of the sacrificial gate and gate spacer structures.

Method 400 continues with operation 406 where a first source or drain region is formed that is coupled to at least the ends of the second layers of the first fin section. At least a portion of the first source or drain region may be epitaxially grown from exposed tips of the second layers (e.g., grown from semiconductor seed material), while an internal dielectric spacer material fills a region between the second layers and adjacent to the ends of the second layers. In some embodiments, the first source or drain region includes an epitaxial fill material of a more highly doped semiconductor material compared to the semiconductor material grown from the ends of the second layers. An insulator layer may be formed over the first source or drain region to isolate the first source or drain region from any additional epitaxial regions formed above it.

Method 400 continues with operation 408 where a second source or drain region is formed that is coupled to at least the ends of the fourth layers of the second fin section. At least a portion of the second source or drain region may be epitaxially grown from exposed tips of the fourth layers (e.g., grown from semiconductor seed material), while the internal dielectric spacer material fills a region between the fourth layers and adjacent to the ends of the fourth layers. In some embodiments, the second source or drain region includes an epitaxial fill material of a more highly doped semiconductor material compared to the semiconductor material grown from the ends of the fourth layers.

Method 400 continues with operation 410 where a recess is formed through the second source or drain region and through a portion of the first source or drain region. An anisotropic etching process, such as RIE, may be used to etch the recess through an entire thickness of the second source or drain region, and through a portion of the thickness of the first source or drain region, in some examples. the depth of the recess may be limited by the fabrication process as the longer the etching process is performed, the wider the recess can become. According to some embodiments, the recess has a depth between about 50 nm and about 70 nm. Note that this description for the recess applies to the formation of a frontside contact. For a backside contact, an anisotropic etching process, such as RIE, may be used to etch the recess through an entire thickness of the first source or drain region, and through a portion of the thickness of the second source or drain region, according to some embodiments.

Method 400 continues with operation 412 where a first conductive material is formed on the inner surface of the recess. The first conductive material includes a single refractory metal or a non-reactive metal or metal compound, according to some embodiments. For example, the first conductive material includes one of W, Mo, Ru, or Co. In some other examples, the first conductive material can include non-reactive metal compounds such as MoSi or TaSi which have been silicized before being deposited. The first conductive material may be formed as a layer over the inner surface of the recess that does not fill the entire volume of the recess.

According to an embodiment, the first conductive material is deposited on the inner surface of the recess using a PVD process, such as sputtering or metal evaporation. Using a PVD process avoids the use of potentially reactive elements, such as fluorine, which are typically used during a CVD process. Since the first conductive material is a non-reactive metal or metal compound, it does not react with the epitaxial material of the first and third source or drain regions to form any silicide or germanide at the interface between conductive the first conductive material and the epitaxial material, according to an embodiment. Accordingly, there is minimal or no diffusion of elements across the boundary between the first conductive material and the source or drain regions leading to a sharp material contrast at the boundary (e.g. no visible material gradient at the boundary).

Method 400 continues with operation 414 where a second conductive material is formed within a remainder of the recess and on the first conductive material. The second conductive material may include the same material composition as the first conductive material. Accordingly, the second conductive material includes a single refractory metal or a non-reactive metal or metal compound, according to some embodiments. For example, the second conductive material includes one of W, Mo, Ru, or Co. In some other examples, the second conductive material can include non-reactive metal compounds such as MoSi or TaSi which have been silicized before being deposited. In some examples, the resulting conductive contact (which includes both the first conductive material and the second conductive material) has a continuous body of conductive material with no visible seam present between the first conductive material and the second conductive material. In some other examples, based on the deposition method and/or parameters, a seam may be visible between the first conductive material and the second conductive material.

According to some embodiments, the second conductive material may be deposited using a different deposition process compared to the first conductive material. For example, the second conductive material may be deposited using CVD to fill the remainder of the recess. According to some embodiments, the final conductive contact includes a non-reactive metal or metal compound at least at the interface between the conductive contact and the epitaxial material of the first and second source or drain regions. The non-reactive metal or metal compound may also be present continuously throughout both the first conductive material and the second conductive material such that the conductive contact has the same material composition throughout its entire body.

### Example System

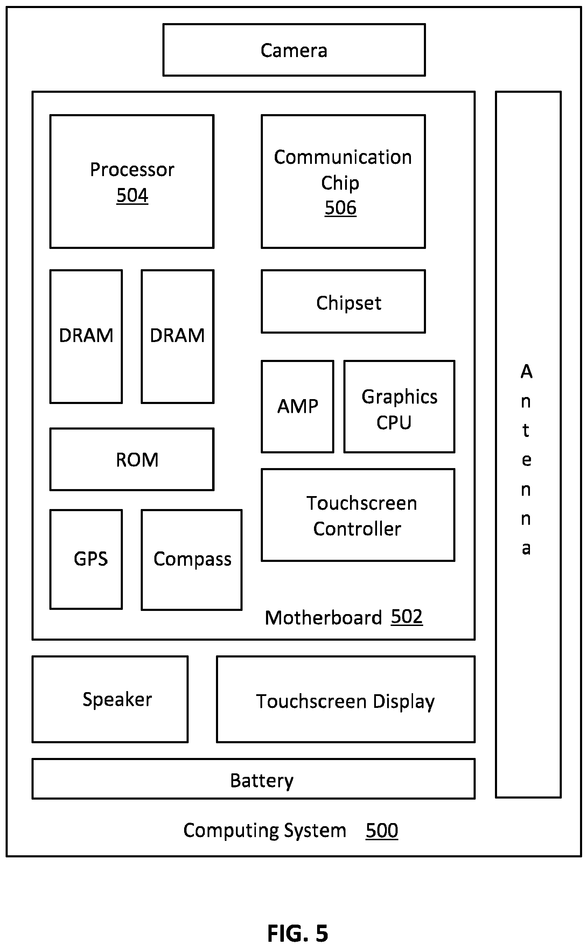

Figure 5 is an example computing system implemented with one or more of the integrated circuit structures as disclosed herein, in accordance with some embodiments of the present disclosure. As can be seen, the computing system 500 houses a motherboard 502. The motherboard 502 may include a number of components, including, but not limited to, a processor 504 and at least one communication chip 506, each of which can be physically and electrically coupled to the motherboard 502, or otherwise integrated therein. As will be appreciated, the motherboard 502 may be, for example, any printed circuit board (PCB), whether a main board, a daughterboard mounted on a main board, or the only board of system 500, etc.

Depending on its applications, computing system 500 may include one or more other components that may or may not be physically and electrically coupled to the motherboard 502. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 500 may include one or more integrated circuit structures or devices configured in accordance with an example embodiment (e.g., a module including an integrated circuit device on a substrate, the substrate having a stacked configuration of semiconductor devices, as variously provided herein). In some embodiments, multiple functions can be integrated into one or more chips (e.g., for instance, note that the communication chip 506 can be part of or otherwise integrated into the processor 504).

The communication chip 506 enables wireless communications for the transfer of data to and from the computing system 500. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 506 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 500 may include a plurality of communication chips 506. For instance, a first communication chip 506 may be dedicated to shorter range wireless communications such as Wi-Fi and Bluetooth and a second communication chip 506 may be dedicated to longer range wireless communications such as GPS, EDGE, GPRS, CDMA, WiMAX, LTE, Ev-DO, and others.

The processor 504 of the computing system 500 includes an integrated circuit die packaged within the processor 504. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 506 also may include an integrated circuit die packaged within the communication chip 506. In accordance with some such example embodiments, the integrated circuit die of the communication chip includes one or more semiconductor devices as variously described herein. As will be appreciated in light of this disclosure, note that multi-standard wireless capability may be integrated directly into the processor 504 (e.g., where functionality of any chips 506 is integrated into processor 504, rather than having separate communication chips). Further note that processor 504 may be a chip set having such wireless capability. In short, any number of processor 504 and/or communication chips 506 can be used. Likewise, any one chip or chip set can have multiple functions integrated therein.

In various implementations, the computing system 500 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 500 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is am integrated circuit that includes a first semiconductor device having one or more first semiconductor bodies extending in a first direction between a first source or drain region and a second source or drain region and a second semiconductor device having one or more second semiconductor bodies extending in the first direction between a third source or drain region and a fourth source or drain region. The one or more first semiconductor bodies are spaced vertically from the one or more second semiconductor bodies in a second direction different from the first direction, and the third source or drain region is spaced vertically from the first source or drain region in the second direction. The integrated circuit also includes an insulating layer between the first source or drain region and the third source or drain region and a conductive contact extending through an entire thickness of the third source or drain region and at least a portion of a thickness of the first source or drain region. The conductive contact has a same material composition present throughout an entire body of the conductive contact, and the conductive contact directly contacts a portion of the third source or drain region and a portion of the first source or drain region.

Example 2 includes the subject matter of Example 1, wherein the one or more first semiconductor bodies and the one or more second semiconductor bodies comprise germanium, silicon, or any combination thereof.

Example 3 includes the subject matter of Example 1 or 2, wherein the one or more first semiconductor bodies is n-type silicon and the one or more second semiconductor bodies is p-type silicon.

Example 4 includes the subject matter of any one of Examples 1-3, wherein a vertical distance between the one or more first semiconductor bodies and the one or more second semiconductor bodies is between about 30 nm and about 80 nm.

Example 5 includes the subject matter of any one of Examples 1-4, wherein the conductive contact comprises a refractory metal.

Example 6 includes the subject matter of any one of Examples 1-5, wherein the conductive contact comprises any one of tungsten (W), molybdenum (Mo), ruthenium (Ru), or cobalt (Co).

Example 7 includes the subject matter of any one of Examples 1-6, wherein the conductive contact has an aspect ratio between 4:1 and 8:1.

Example 8 includes the subject matter of any one of Examples 1-7, wherein the third source or drain region includes one or more first regions that contact corresponding second semiconductor bodies and a second region that contacts each of the one or more first regions, wherein the second region has a higher dopant concentration than each of the one or more first regions.

Example 9 includes the subject matter of Example 8, wherein the conductive contact extends through the second region and does not contact at least one of the one or more first regions.

Example 10 includes the subject matter of Example 9, wherein the conductive contact does not contact any of the one or more first regions.

Example 11 includes the subject matter of any one of Examples 1-10, wherein the conductive contact does not contain any germanium (Ge).

Example 12 includes the subject matter of any one of Examples 1-11, wherein no material gradient is present at a boundary between the conductive contact and the first source or drain region or between the conductive contact and the third source or drain region.

Example 13 is a printed circuit board comprising the integrated circuit of any one of Examples 1-12.

Example 14 is an electronic device that includes a chip package comprising one or more dies. At least one of the one or more dies includes a first semiconductor device having one or more first semiconductor nanoribbons extending in a first direction between a first source or drain region and a second source or drain region and a second semiconductor device having one or more second semiconductor nanoribbons extending in the first direction between a third source or drain region and a fourth source or drain region. The one or more first semiconductor nanoribbons are spaced vertically from the one or more second semiconductor nanoribbons in a second direction different from the first direction, and the third source or drain region is spaced vertically from the first source or drain region in the second direction. The integrated circuit also includes an insulating layer between the first source or drain region and the third source or drain region and a conductive contact extending through an entire thickness of the third source or drain region and at least a portion of a thickness of the first source or drain region. The conductive contact has a same material composition present throughout an entire body of the conductive contact, and the conductive contact directly contacts a portion of the third source or drain region and a portion of the first source or drain region.

Example 15 includes the subject matter of Example 14, wherein the one or more first semiconductor nanoribbons and the one or more second semiconductor nanoribbons comprise germanium, silicon, or any combination thereof.

Example 16 includes the subject matter of Example 14 or 15, wherein the one or more first semiconductor nanoribbons is n-type silicon and the one or more second semiconductor nanoribbons is p-type silicon.

Example 17 includes the subject matter of any one of Examples 14-16, wherein a vertical distance between the one or more first semiconductor nanoribbons and the one or more second semiconductor nanoribbons is between about 30 nm and about 80 nm.

Example 18 includes the subject matter of any one of Examples 14-17, wherein the conductive contact comprises a refractory metal.

Example 19 includes the subject matter of any one of Examples 14-18, wherein the conductive contact comprises any one of tungsten (W), molybdenum (Mo), ruthenium (Ru), or cobalt (Co).

Example 20 includes the subject matter of any one of Examples 14-19, wherein the conductive contact has an aspect ratio between 4:1 and 8:1.

Example 21 includes the subject matter of any one of Examples 14-20, wherein the third source or drain region includes one or more first regions that contact corresponding second semiconductor nanoribbons and a second region that contacts each of the one or more first regions, wherein the second region has a higher dopant concentration than each of the one or more first regions.

Example 22 includes the subject matter of Example 21, wherein the conductive contact extends through the second region and does not contact at least one of the one or more first regions.

Example 23 includes the subject matter of Example 22, wherein the conductive contact does not contact any of the one or more first regions.

Example 24 includes the subject matter of any one of Examples 14-23, wherein the conductive contact does not contain any germanium (Ge).

Example 25 includes the subject matter of any one of Examples 14-24, wherein no material gradient is present at a boundary between the conductive contact and the first source or drain region or between the conductive contact and the third source or drain region.

Example 26 includes the subject matter of any one of Examples 14-25, further comprising a printed circuit board, wherein the chip package is attached to the printed circuit board.

Example 27 is a method of forming an integrated circuit. The method includes forming a multilayer fin having a first section with first material layers alternating with second material layers, the second material layers comprising a semiconductor material suitable for use as a nanoribbon channel, and a second section over the first section and comprising third material layers alternating with fourth material layers, wherein the fourth material layers comprise a semiconductor material suitable for use as a nanoribbon channel; forming a first source or drain region coupled to the ends of the second material layers; forming an insulating layer over the first source or drain region; forming a second source or drain region coupled to the ends of the fourth material layers and over the insulating layer; forming a recess through an entire thickness of the second source or drain region and through at least a portion of the first source or drain region; lining walls of the recess with a first conductive material using a first deposition technique; and filling a remaining portion of the recess with a second conductive material using a second deposition technique different from the first deposition technique.

Example 28 includes the subject matter of Example 27, wherein the first and third material layers comprise silicon and germanium and the second and fourth material layers comprise silicon.

Example 29 includes the subject matter of Example 27 or 28, wherein the second section of the fin is separated from the first section of the fin by a vertical distance between about 30 nm and about 80 nm.

Example 30 includes the subject matter of any one of Examples 27-29, further comprising removing the first and third material layers.

Example 31 includes the subject matter of Example 30, further comprising forming a first gate structure around portions of the second material layers and forming a second gate structure around portions of the fourth material layers.

Example 32 includes the subject matter of any one of Examples 27-31, wherein the first deposition technique is a physical vapor deposition (PVD) technique.

Example 33 includes the subject matter of any one of Examples 27-32, wherein the second deposition technique is a chemical vapor deposition (CVD) technique.

Example 34 includes the subject matter of any one of Examples 27-33, wherein the first and second conductive materials comprise a refractory metal.

Example 35 includes the subject matter of any one of Examples 27-34, wherein the first conductive material has the same composition as the second conductive material.

Example 36 is an integrated circuit that includes a first semiconductor device having one or more first semiconductor bodies extending in a first direction between a first source or drain region and a second source or drain region and a second semiconductor device having one or more second semiconductor bodies extending in the first direction between a third source or drain region and a fourth source or drain region. The one or more first semiconductor bodies are spaced vertically from the one or more second semiconductor bodies in a second direction different from the first direction, and the third source or drain region is spaced vertically from the first source or drain region in the second direction. The integrated circuit also includes an insulating layer between the first source or drain region and the third source or drain region and a conductive contact extending through an entire thickness of the third source or drain region and at least a portion of a thickness of the first source or drain region. The conductive contact includes a conductive layer directly contacting a portion of the third source or drain region and a portion of the first source or drain region and a conductive material on the conductive layer and having a same refractory metal as the conductive layer.

Example 37 includes the subject matter of Example 36, wherein the refractory metal is any one of tungsten (W), molybdenum (Mo), ruthenium (Ru), or cobalt (Co).

Example 38 includes the subject matter of Example 36 or 37, wherein the conductive contact has a same material composition present throughout an entire body of the conductive contact.

Example 39 includes the subject matter of any one of Examples 36-38, wherein the conductive contact does not contain any germanium (Ge).

Example 40 includes the subject matter of any one of Examples 36-39, wherein no material gradient is present at a boundary between the conductive layer and the first source or drain region or between the conductive layer and the third source or drain region.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a first semiconductor device having one or more first semiconductor bodies extending in a first direction between a first source or drain region and a second source or drain region;
a second semiconductor device having one or more second semiconductor bodies extending in the first direction between a third source or drain region and a fourth source or drain region, the one or more first semiconductor bodies spaced vertically from the one or more second semiconductor bodies in a second direction different from the first direction, the third source or drain region spaced vertically from the first source or drain region in the second direction;
an insulating layer between the first source or drain region and the third source or drain region; and
a conductive contact extending through an entire thickness of the third source or drain region and at least a portion of a thickness of the first source or drain region, wherein the conductive contact has a same material composition present throughout an entire body of the conductive contact, and wherein the conductive contact directly contacts a portion of the third source or drain region and a portion of the first source or drain region.

2. The integrated circuit of claim 1, wherein the one or more first semiconductor bodies and the one or more second semiconductor bodies comprise germanium, silicon, or any combination thereof.

3. The integrated circuit of claim 1 or 2, wherein the one or more first semiconductor bodies is n-type silicon and the one or more second semiconductor bodies is p-type silicon.

4. The integrated circuit of any one of claims 1 through 3, wherein a vertical distance between the one or more first semiconductor bodies and the one or more second semiconductor bodies is between about 30 nm and about 80 nm.

5. The integrated circuit of any one of claims 1 through 4, wherein the conductive contact comprises a refractory metal.

6. The integrated circuit of any one of claims 1 through 5, wherein the conductive contact comprises any one of tungsten (W), molybdenum (Mo), ruthenium (Ru), or cobalt (Co).

7. The integrated circuit of any one of claims 1 through 6, wherein the conductive contact has an aspect ratio between 4:1 and 8:1.

8. The integrated circuit of any one of claims 1 through 8, wherein the third source or drain region includes one or more first regions that contact corresponding second semiconductor bodies and a second region that contacts each of the one or more first regions, wherein the second region has a higher dopant concentration than each of the one or more first regions.

9. The integrated circuit of claim 8, wherein the conductive contact does not contact any of the one or more first regions.

10. The integrated circuit of claim 9, wherein the conductive contact extends through the second region and does not contact at least one of the one or more first regions.

11. The integrated circuit of any one of claims 1 through 10, wherein the conductive contact does not contain any germanium (Ge).

12. The integrated circuit of any one of claims 1 through 11, wherein no material gradient is present at a boundary between the conductive contact and the first source or drain region or between the conductive contact and the third source or drain region.

13. A printed circuit board comprising the integrated circuit of any one of claims 1 through 12.

14. An electronic device, comprising: a chip package comprising one or more dies, at least one of the one or more dies comprising the integrated circuit of claim 1, wherein the one or more first semiconductor bodies are one or more first semiconductor nanoribbons, and the one or more second semiconductor bodies are one or more second semiconductor nanoribbons.

15. The electronic device of claim 14, wherein:
the conductive contact comprises any one of tungsten (W), molybdenum (Mo), ruthenium (Ru), or cobalt (Co);
the conductive contact has an aspect ratio between 4:1 and 8:1;
the third source or drain region includes one or more first regions that contact corresponding second semiconductor nanoribbons and a second region that contacts each of the one or more first regions, wherein the second region has a higher dopant concentration than each of the one or more first regions;
the conductive contact does not contact any of the one or more first regions; and
no material gradient is present at a boundary between the conductive contact and the first source or drain region or between the conductive contact and the third source or drain region.
